# EUROPÄISCHE PATENTANMELDUNG

(11) **EP 3 561 529 A1**
(43) Veröffentlichungstag der Anmeldung: **30.10.2019**
(21) Anmeldenummer: 19158246.9
(22) Anmeldetag: 20.02.2019
(51) Int. Cl.: G01R 31/00, G01R 31/02, G01R 31/36, G01R 31/396

(54) **VERFAHREN ZUR ERKENNUNG EINER FEHLFUNKTION, INSBESONDERE EINES KURZSCHLUSSSTROMS, IN EINER TRAKTIONSBATTERIEANORDNUNG**

(30) Priorität: 09.03.2018 DE 102018105505
(71) Anmelder: MAN Truck & Bus SE, 80995 München (DE)
(72) Erfinder: Braun, Reimar, 81735 München (DE)
(74) Vertreter: v. Bezold & Partner Patentanwälte - PartG mbB

(57) **Zusammenfassung**

Die Erfindung betrifft ein Verfahren zur Erkennung einer Fehlfunktion, insbesondere eines Kurzschlussstroms, in einer Traktionsbatterieanordnung (10) mit mehreren miteinander verbundenen, insbesondere parallel geschalteten, Traktionsbatterien (12, 14, 16) in einem Kraftfahrzeug mit mehreren elektrischen Geräten (18 - 32). Das Verfahren weist ein Aufstellen einer Strombilanz, die ein Stromangebot durch die Traktionsbatterieanordnung (10) und die mehreren elektrischen Geräte (18 - 32) einer Stromanforderung durch die Traktionsbatterieanordnung (10) und die mehreren elektrischen Geräte (18 - 32) gegenüberstellt, auf. Das Verfahren weist ein Erkennen einer Fehlfunktion basierend auf einem Ungleichgewicht in der Strombilanz auf. Es findet somit eine Strombilanzierung statt, bei der alle Stromquellen und Stromsenken betrachtet werden können. Wenn bspw. kein Gleichgewicht vorliegt, dann deutet dies auf ein Fehlverhalten bzw. auf ein kommendes Fehlverhalten der Traktionsbatterieanordnung (10) hin.

## Beschreibung

Die Erfindung betrifft ein Verfahren zur Erkennung einer Fehlfunktion, insbesondere eines Kurzschlussstroms, in einer Traktionsbatterieanordnung mit mehreren miteinander verbundenen, insbesondere parallel geschalteten, Traktionsbatterien in einem Kraftfahrzeug mit mehreren elektrischen Geräten.

Die US 2012/0166031 A offenbart bspw. ein Batteriesteuersystem für ein Kraftfahrzeug. In einer Batterieeinheit aus mehreren parallelen Batteriemodulen werden abnormale Zustände, z. B. ein zu hoher Laststrom, verhindert, indem ein maximal erlaubter Strom auf Basis von temperatur- und ladezustandsabhängigen Referenzwerten für jede Batterie berechnet wird.

Kurzschlüsse in HV-Batteriesystemen können bspw. aufgrund von Produktionsfehlern in der Zelle auftreten. Beispielsweise können Partikel, Verunreinigungen usw. zwischen den Zellwickeln vorkommen.

Nachteilig an bekannten Verfahren zur Erkennung von Fehlfunktionen kann sein, dass diese insbesondere auf einem Vergleich mit einer maximalen dynamischen Stromgrenze der Traktionsbatterien basieren. Dies kann in bestimmten Anordnungen dazu führen, dass elektrische Kurzschlüsse erst spät oder - im ungünstigsten Fall - gar nicht erkannt werden. Als Beispiel wird auf eine Master-Slave-Traktionsbatterieanordnung mit mehreren parallel geschalten Traktionsbatterien (z. B. eine Master-Traktionsbatterie und fünf Slave-Traktionsbatterie) Bezug genommen. Die Fahrzeugsteuerung kommuniziert lediglich mit der Batteriesteuerung, die der Master-Traktionsbatterie zugeordnet ist. Es kann bekannt sein, dass alle Traktionsbatterien beispielsweise eine maximal dynamische Stromgrenze von 200 A haben. Eine einzelne Überwachung der Slave-Traktionsbatterien hinsichtlich der Überschreitung der jeweiligen maximalen dynamischen Stromgrenze von 200 A kann bspw. nicht vorgenommen werden. Es wird vereinfacht davon ausgegangen, dass die gesamte Traktionsbatterieanordnung eine maximale dynamische Stromgrenze von 1200 A (6 x 200 A) aufweist. Wird von der Traktionsbatterieanordnung ein elektrischer Summenstrom unterhalb von 1200 A ausgegeben, so wird davon ausgegangen, dass kein Fehler vorliegt. Jedoch kann es passieren, dass ein elektrischer Summenstrom von 1000 A von lediglich einer einzigen Slave-Traktionsbatterie mit einer Fehlfunktion geliefert wird, wobei die anderen Slave-Traktionsbatterien ausgeschaltet oder deaktiviert sind. Es ist es auch möglich, dass ein elektrischer Strom von einer Traktionsbatterie zwar unterhalb von deren maximaler dynamischer Stromgrenze liegt, aber dennoch nicht korrekt ist, da ein Strombedarf bzw. Stromanforderung von elektrischen Nebenverbrauchern nicht entsprechend hoch ist.

Der Erfindung liegt die Aufgabe zu Grunde, ein alternatives und/oder verbessertes Verfahren zur Erkennung einer Fehlfunktion, insbesondere eines Kurzschlussstroms, in einer Traktionsbatterieanordnung zu schaffen, mit der insbesondere Nachteile im Stand der Technik überwunden werden können.

Die Aufgabe wird gelöst durch die Merkmale des unabhängigen Anspruchs 1. Vorteilhafte Weiterbildungen sind in den abhängigen Ansprüchen und der Beschreibung angegeben.

Das Verfahren ist zur Erkennung einer Fehlfunktion, insbesondere eines Kurzschlussstroms, zweckmäßig in einer Traktionsbatterieanordnung (zum Beispiel Hochvolt-Traktionsbatterieanordnung) mit bspw. mehreren miteinander verbundenen, insbesondere parallel geschalteten, Traktionsbatterien (zum Beispiel Hochvolt-Traktionsbatterie) in einem Kraftfahrzeug mit mehreren (weiteren) elektrischen Geräten (zum Beispiel Inverter, elektrische Antriebseinheit, Hochvolt-Heizer, Hochvolt-Luftkompressor, Bordladegerät und/oder Bordnetzladewandler zu Niedrigvolt-Bordnetz) geeignet. Das Verfahren weist ein Aufstellen einer Strombilanz auf, die ein (z. B. summarisches, aktuelles, derzeitiges, tatsächliches und/oder momentanes) Stromangebot durch die Traktionsbatterieanordnung und die mehreren elektrischen Geräte einer (z. B. summarischen, aktuellen, derzeitigen, tatsächlichen und/oder momentanen) Stromanforderung (bzw. Last) durch die Traktionsbatterieanordnung und die mehreren elektrischen Geräte gegenüberstellt. Das Verfahren weist ferner ein Erkennen einer Fehlfunktion (z. B. in der Traktionsbatterieanordnung) basierend auf einem Ungleichgewicht in der Strombilanz auf.

Die vorliegende Offenbarung schafft ein Verfahren, bei dem ein Gleichgewicht bzw. Ungleichgewicht zwischen einem Strombedarf / einer Stromanforderung insbesondere durch die elektrischen Geräte und einem Stromangebot insbesondere durch die Traktionsbatterieanordnung betrachtet wird. Es findet eine Strombilanzierung statt, bei der alle Stromquellen und Stromsenken betrachtet werden können. Wenn bspw. kein Gleichgewicht vorliegt, dann deutet dies auf ein Fehlverhalten bzw. auf ein kommendes Fehlverhalten der Traktionsbatterieanordnung hin. Insbesondere kann erkannt werden, dass bei einem Stromangebot, z. B. durch die Traktionsbatterieanordnung, das größer als eine Stromanforderung, z. B. durch die elektrischen Geräte, ist, eine Fehlfunktion in der Traktionsbatterieanordnung vorliegen kann. Das Verfahren ermöglicht zudem die Einleitung von schnellen Notfallmaßnahmen, wenn andere Sicherungsfunktionen der Traktionsbatterien oder der Traktionsbatterieanordnung bereits versagt haben (z. B. Verschweißen von Hochvolt-Schützen) und/oder erst zeitverzögert wirken (z. B. Schmelzsicherung), insbesondere im Falle von hohen Kurzschlussströmen.

Es ist möglich, dass die mehreren elektrischen Geräte und/oder die mehreren Traktionsbatterien eine Selbstdiagnose zur Prüfung oder Sicherstellung der eigenen Funktionsfähigkeit durchführen können (z. B. nach ISO 26262). Damit kann bspw. ausgeschlossen werden, dass keine Fehlfunktion in einer der mehreren elektrischen Geräte aufgetreten ist und/oder plausibilisiert werden, dass die Fehlfunktion tatsächlich in der Traktionsbatterieanordnung aufgetreten ist.

In einem besonders bevorzugten Ausführungsbeispiel weist der Schritt des Aufstellens der Strombilanz ein Ermitteln (z. B. Berechnen, Erfassen, Messen) eines ersten elektrischen Summenstroms, der in Summe von der Traktionsbatterieanordnung angefordert (bzw. zu der Traktionsbatterieanordnung zugeführt) oder bereitgestellt wird, auf. Der Schritt weist ferner ein Ermitteln (z. B. Berechnen, Erfassen, Messen) eines zweiten elektrischen Summenstroms, der in Summe von den mehreren elektrischen Geräten angefordert oder von den mehreren elektrischen Geräten bereitgestellt wird, auf. Damit kann zweckmäßig als Systemgrenze bzw. Bilanzgrenze ein Übergang zwischen der Traktionsbatterieanordnung und einem (Hochvolt-) Bordnetz, an das die elektrischen Geräte angeschlossen sind, definiert sein. Diese Bilanzgrenze ermöglicht insbesondere eine Fehlfunktion in der Traktionsbatterieanordnung zu ermitteln. Es ist möglich, dass sowohl der erste elektrische Summenstrom als auch der zweite elektrische Summenstrom zum Stromangebot und zur Stromanforderung beitragen.

In einer bevorzugten Weiterbildung basiert der Schritt des Erkennens einer Fehlfunktion auf einem Unterschied zwischen dem ersten elektrischen Summenstrom und dem zweiten elektrischen Summenstrom. Zweckmäßig kann dadurch beispielsweise festgestellt werden, ob ein Stromangebot durch die Traktionsbatterieanordnung (erster elektrischer Summenstrom) ungleich einer Stromanforderung durch die elektrischen Geräte (z. B. größer als eine Stromanforderung durch die elektrischen Geräte) ist.

Zweckmäßig stellt der erste elektrische Summenstrom das Stromangebot dar und der zweite elektrische Summenstrom die Stromanforderung. Es ist allerdings auch möglich, dass beispielsweise in einem Rekuperationsmodus des Kraftfahrzeugs der zweite elektrische Summenstrom als Kombination aus einem Stromangebot (durch die Rekuperation) und einer Stromanforderung (durch elektrische Nebenverbraucher) gebildet ist.

Insbesondere kann es sich bei der Traktionsbatterieanordnung um eine Hochvolt-Traktionsbatterieanordnung und/oder bei den Traktionsbatterien um Hochvolt-Traktionsbatterien handeln.

Insbesondere kann sich der im Rahmen der vorliegenden Offenbarung verwendete Begriff "Hochvolt" auf eine Netzspannung von mehr als 50 V Gleichspannung oder Wechselspannung oder mehr als 60 V Gleichspannung oder Wechselspannung beziehen.

Zweckmäßig kann sich der im Rahmen der vorliegenden Offenbarung verwendete Begriff "Niedrigvolt" auf eine Netzspannung von weniger als 50 V beziehen. Beispielsweise kann die Netzspannung 12 V, 24 V, 42 V oder 48 V Gleichspannung betragen.

In einem Ausführungsbeispiel wird der erste elektrische Summenstrom als eine Summe von allen elektrischen Einzelströmen, die von den mehreren Traktionsbatterien angefordert bzw. zu den mehreren Traktionsbatterien zugeführt und von den mehreren Traktionsbatterien bereitgestellt werden, ermittelt. Beispielsweise können zur Ermittlung der bereitgestellten elektrischen Einzelströme entsprechende Strommesser oder Spannungsmesser an den Traktionsbatterien vorgesehen sein. Zweckmäßig kann bei der Verwendung eines Spannungsmessers der jeweilige Innenwiderstand, z. B. der Zellen, bekannt sein und/oder anhand von Tabellen interpoliert werden. Beispielsweise können auch Übergangswiderstände berücksichtigt werden, um eine genauere Strombestimmung zu ermöglichen. Es ist möglich, dass zur Ermittlung der elektrischen Einzelströme zusätzlich oder alternativ auf Steuerinformationen zurückgegriffen wird.

In einem weiteren Ausführungsbeispiel weisen die mehreren elektrischen Geräte einen Inverter, der einer elektrischen Antriebseinheit zugeordnet ist, mindestens einen elektrischen Nebenverbraucher (z. B. Heizer, Luftkompressor und/oder Bordnetzladewandler usw.) und/oder ein Bordladegerät auf. Zweckmäßig kann der zweite elektrische Summenstrom als eine Summe von allen elektrischen Einzelströmen, die von dem Inverter und dem Bordladegerät bereitgestellt und von den elektrischen Nebenverbrauchern und dem Inverter oder der Antriebseinheit angefordert werden, ermittelt werden. Zur Ermittlung der elektrischen Einzelströme kann auf entsprechende Strommesser oder Spannungsmesser und/oder auf Steuerinformationen zurückgegriffen werden.

In einer Ausführungsform wird eine Fehlfunktion erkannt, wenn das Ungleichgewicht außerhalb eines vorbestimmten Toleranzbereichs liegt. Der Toleranzbereich kann beispielsweise bekannte oder geschätzte Messtoleranzen, Fertigungstoleranzen und/oder Verschleißtoleranzen berücksichtigen.

In einer Weiterbildung wird ein (zum Beispiel vorhandener oder sich aktuell einstellender) elektrischer Kurzschluss in der Traktionsbatterieanordnung erkannt, wenn unter Berücksichtigung eines vorbestimmen Toleranzbereichs (z. B. Messtoleranzen, Fertigungstoleranzen und/oder Verschleißtoleranzen) der erste elektrische Summenstrom größer als der zweite elektrische Summenstrom ist.

In einer weiteren Ausführungsform beziehen sich der erste elektrische Summenstrom und der zweite elektrische Summenstrom auf einen gleichen Zeitpunkt und/oder die elektrischen Einzelströme werden zu einem gleichen Zeitpunkt (z. B. direkt und/oder indirekt) erfasst, insbesondere (z. B. direkt und/oder indirekt) gemessen.

In einer Ausführungsvariante ist die Traktionsbatterieanordnung eine Master-Slave-Anordnung, mit einer Master-Traktionsbatterie und mehreren, insbesondere parallel geschalteten, Slave-Traktionsbatterien. Insbesondere bei derartigen Master-Slave-Anordnungen, bei der typischerweise nur eine Steuerung der Master-Traktionsbatterie mit einer Fahrzeugsteuerung kommuniziert, war es bisher nur auf ungenügende Weise möglich, Fehlfunktionen in der Traktionsbatterieanordnung zu erkennen (vgl. Ausführungen hierzu in der Beschreibungseinleitung).

Zweckmäßig kann mit der Traktionsbatterieanordnung nur mittels einer Steuerung, die der Master-Traktionsbatterie zugeordnet ist, kommuniziert werden.

In einer Weiterbildung übertragen die mehreren Slave-Traktionsbatterien (z. B. entsprechende Steuerungen, die den Slave-Traktionsbatterien zugeordnet sind) jeweils ein Signal, das einen Betriebszustand (z. B. aktiviert, deaktiviert, Drive Mode, Balance Mode usw.) der jeweiligen Slave-Traktionsbatterie angibt, an eine der Master-Traktionsbatterie zugeordnete Steuerung. Alternativ oder zusätzlich übertragen die mehreren Slave-Traktionsbatterien (z. B. entsprechende Steuerungen, die den Slave-Traktionsbatterien zugeordnet sind) jeweils ein Signal, das den jeweils angeforderten bzw. zugeführten oder bereitgestellten elektrischen Einzelstrom angibt, an eine der Master-Traktionsbatterie zugeordnete Steuerung. Zweckmäßig können die Signale der Slave-Traktionsbatterien mit einer eindeutigen Kennung zur Identifikation der jeweiligen Slave-Traktionsbatterie übertragen werden.

In einem Ausführungsbeispiel ermittelt die Steuerung, die der Master-Traktionsbatterie zugeordnet ist, den ersten elektrischen Summenstrom basierend auf einem Signal, das dessen angeforderten bzw. zugeführten oder bereitgestellten elektrischen Einzelstrom angibt, und den von den Slave-Traktionsbatterien empfangenen Signalen.

In einer bevorzugten Weiterbildung weist das Verfahren ferner ein Identifizieren, und insbesondere Abschalten, einer Slave-Traktionsbatterie mit der Fehlfunktion, insbesondere einem elektrischen Kurzschluss, basierend auf den Kennungen und den Signalen von den Slave-Traktionsbatterien auf.

Es ist auch möglich, dass der Schritt des Erkennens einer Fehlfunktion zusätzlich auf einer vorbestimmten oder berechneten maximalen Stromgrenze für jede der mehreren Traktionsbatterien basiert. Zweckmäßig kann eine maximale dynamische Stromgrenze so bestimmt und/oder berechnet werden, dass sie von eine Ladestatus (State-of-Charge - SOC), von einer Temperatur, einer bisherigen Betriebszeit, einem geschätzten Verschleiß und/oder einer Fertigungstoleranz der jeweiligen Traktionsbatterie abhängt.

In einem weiteren Ausführungsbeispiel basiert ein Erkennen einer Fehlfunktion auf einer zeitlichen Veränderung und/oder eines Gradienten des Stromangebots, der Stromanforderung, des Ungleichgewichts, des ersten elektrischen Summenstroms, des zweiten elektrischen Summenstrom, der elektrischen Einzelströme und/oder des Unterschieds.

Beispielsweise können ein Stromangebotsgradient mit einem Stromanforderungsgradient und/oder ein erster Summenstromgradient mit einem zweiten Summenstromgradient usw. verglichen werden.

In einer Weiterbildung basiert ein Erkennen einer Fehlfunktion basierend auf einem Vergleich zwischen einer zeitlichen Veränderung und/oder eines Gradienten eines elektrischen Einzelstroms an einem Inverter, der einer elektrischen Antriebseinheit des Kraftfahrzeugs zugeordnet ist, und einer zeitlichen Veränderung und/oder eines Gradienten des ersten elektrischen Summenstroms und/oder von elektrischen Einzelströmen der mehreren Traktionsbatterien der Traktionsbatterieanordnung.

Zweckmäßig kann die Berücksichtigung von zeitlichen Veränderungen und/oder Gradienten ermöglichen, sehr schnell Fehlfunktionen, insbesondere solche, die sich gerade erst ausbilden, zu erfassen, beispielsweise wenn ein Stromgradient der Stromanforderung durch den Inverter/die elektrische Antriebseinheit kleiner als ein Stromgradient des Stromangebots ist. Es ist beispielsweise möglich, dass unter Berücksichtigung von Toleranzen das Stromangebot und die Stromanforderung noch kein Ungleichgewicht zeigen, während ein Gradientenvergleich bereits auf ein kommendes Ungleichgewicht hinweist.

In einer bevorzugten Ausführungsform weist das Verfahren ferner ein Schalten eines Inverters, der einer elektrischen Antriebseinheit des Kraftfahrzeugs zugeordnet ist, in einen aktiven Kurzschluss, wenn eine Fehlfunktion erkannt wird, auf. Damit kann zweckmäßig verhindert werden, dass es aufgrund von unvorhersehbaren und ungewünschten Drehmomentschüben zu unkontrollierbaren Fahrzuständen des Kraftfahrzeugs kommt (zum Beispiel Ausbrechen des Fahrzeugs).

Die vorliegende Offenbarung ist auch auf ein Kraftfahrzeug, insbesondere ein Nutzfahrzeug (zum Beispiel ein Omnibus oder Lastkraftwagen) gerichtet. Das Kraftfahrzeug weist eine Traktionsbatterieanordnung auf, die beispielsweise mehrere miteinander verbundene, insbesondere parallel geschaltete, Traktionsbatterien aufweist. Das Nutzfahrzeug weist ferner eine Steuerung auf, die zum Ausführen eines Verfahrens wie hierin offenbart eingerichtet ist.

Es ist auch möglich, die Vorrichtung wie hierin offenbart für bspw. Personenkraftwagen und geländegängige Fahrzeuge zu verwenden.

Beispielsweise kann das hierin offenbarte Verfahren sowie die hierin offenbarte Steuerung in Software und/oder in Hardware implementiert sein.

Auch wenn hierin der Begriff "Steuern" verwendet wird, kann damit gleichsam zweckmäßig auch "Regeln" bzw. "Steuern mit Rückkopplung" umfasst sein.

Die zuvor beschriebenen bevorzugten Ausführungsformen und Merkmale der Erfindung sind beliebig miteinander kombinierbar. Weitere Einzelheiten und Vorteile der Erfindung werden im Folgenden unter Bezug auf die beigefügten Zeichnungen beschrieben. Es zeigen:
- Figur 1: ein Blockschaltbild einer Traktionsbatterieanordnung und mehrerer elektrischer Geräte in einem Kraftfahrzeug; und
- Figur 2: ein Flussdiagramm eines beispielhaften Verfahrens gemäß der vorliegenden Offenbarung.

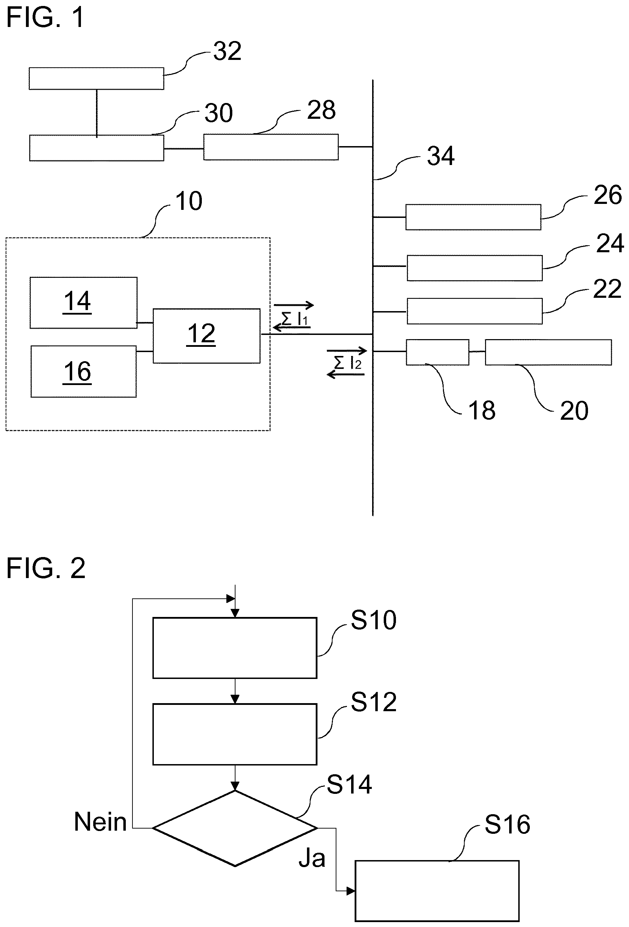

Die Figur 1 zeigt eine Traktionsbatterieanordnung 10 und mehrere elektrische Geräte 18 bis 32. Die elektrischen Geräte 18-32 sind elektrisch mit der Traktionsbatterieanordnung 10 mittels eines Hochvolt-Bordnetzes 34 verbunden. Die elektrischen Geräte 18-32 können, je nach spezifischer Konfiguration, elektrische Energie von der Traktionsbatterieanordnung 10 empfangen oder zu der Traktionsbatterieanordnung 10 zuführen. Die Traktionsbatterieanordnung, die elektrischen Geräte 18-32 und das Hochvolt-Bordnetz 34 sind in einem Kraftfahrzeug, insbesondere einem Nutzfahrzeug, umfasst. Zum Beispiel kann das Nutzfahrzeug als ein Omnibus oder ein Lastkraftwagen ausgebildet sein. Die elektrische Energie der Traktionsbatterieanordnung 10 dient insbesondere zur Fortbewegung bzw. zum Antreiben des Kraftfahrzeugs.

Die Traktionsbatterieanordnung 10 umfasst mehrere Traktionsbatterien 12, 14, 16, die insbesondere parallel geschaltet sind. Die Traktionsbatterien 12, 14, 16 weisen jeweils eine Mehrzahl von seriell und/oder parallel geschalteten Zellen oder Zellmodulen zum Speichern von elektrischer Energie auf. Zweckmäßig sind die Traktionsbatterien 12, 14, 16 als Hochvolt-Traktionsbatterien ausgebildet.

Im Ausführungsbeispiel ist die Traktionsbatterieanordnung 10 in einer Master-Slave-Anordnung konfiguriert. Die Traktionsbatterie 12 ist die Master-Traktionsbatterie. Geräte, z. B. eine Fahrzeugsteuerung, außerhalb der Traktionsbatterieanordnung 10 kommunizieren zweckmäßig lediglich mit der Master-Traktionsbatterie 12. Die Slave-Traktionsbatterien 14 und 16 kommunizieren innerhalb der Traktionsbatterieanordnung 10 mit der Master-Traktionsbatterie 12. Insbesondere werden die Slave-Traktionsbatterien 14 und 16 von der Master-Traktionsbatterie 12 gesteuert. Es ist auch möglich, dass mehr oder weniger als zwei Slave-Traktionsbatterien vorgesehen sind.

Die elektrischen Geräte 18 bis 32 umfassen einen Inverter bzw. AC-DC-Wandler 18 und eine elektrische Antriebseinheit 20. Der Inverter 18 wandelt zwischen einer Wechselspannung, die an der elektrischen Antriebseinheit 20 anliegt, und einer Gleichspannung, die im Hochvolt-Bordnetz 34 anliegt. Die elektrische Antriebseinheit 20 dient zum Antreiben des Kraftfahrzeugs. Zum Antreiben des Kraftfahrzeugs wird elektrische Energie von der Traktionsbatterieanordnung 10 über das Hochvolt-Bordnetz 34 und den Inverter 18 zu der elektrischen Antriebseinheit 20 zugeführt. Die elektrische Antriebseinheit 20 kann durch Rekuperation mechanische Energie in elektrische Energie wandeln. Die elektrische Energie kann von der elektrischen Antriebseinheit 20 über den Inverter 18 und das Hochvolt-Bordnetz 34 zum Laden der Traktionsbatterieanordnung 10 genutzt werden. Die durch Rekuperation erzeugte elektrische Energie kann auch zu anderen elektrischen Geräten 24 bis 32 zugeführt werden.

Zusätzlich können ein Bordladegerät (Onboard-Charger) 22, ein Heizer 24 und ein Luftpresser bzw. Luftkompressor 26 umfasst sein. Mittels des Bordladegeräts 22 kann die Traktionsbatterieanordnung 10 von extern bspw. mittels einer Ladesäule geladen werden. Der Heizer 24 dient zum Bereitstellen von Wärmeenergie. Der Heizer 24 kann insbesondere als ein Hochvolt-Heizer ausgebildet sein. Der Luftkompressor 26 dient zum Bereitstellen von Druckluft, insbesondere für eine Bremsanlage des Kraftfahrzeugs. Der Luftkompressor 26 kann zweckmäßig als ein Hochvolt-Luftkompressor ausgebildet sein.

Ferner können ein Bordnetzladewandler 28, ein Niedrigvolt-Bordnetz 30 und mehrere elektrische Niedrigvolt-Geräte 32 umfasst sein. Der Bordnetzladewandler 28 wandelt zwischen einer Hochvolt-Spannung (zum Beispiel 60 V) des Hochvolt-Bordnetzes 34 und einer Niedrigvolt-Spannung (zum Beispiel 24 V) des Niedrigvolt-Bordnetzes 30. Die elektrischen Niedrigvolt-Geräte 32, die mit elektrischer Energie über das Niedrigvolt-Bordnetzes 30 versorgt werden, können beispielsweise Pumpen, Kompressoren, Lenkpumpen usw. aufweisen.

Unter Bezugnahme auf die Figuren 1 und 2 ist nachfolgend ein Verfahren zur Erkennung einer elektrischen Fehlfunktion, insbesondere in Form eines Kurzschlussstroms in der Traktionsbatterieanordnung 10, beschrieben. Das Verfahren kann im Kraftfahrzeug zumindest teilweise in Software und/oder zumindest teilweise in Hardware implementiert sein.

Zunächst ist zu berücksichtigen, dass alle Hochvolt-Komponenten 10-28 über eine Selbstdiagnosefunktion verfügen können. Die Selbstdiagnosefunktion kann eine Eigenprüfung der jeweiligen Hochvolt-Komponente 10-28 ermöglichen. Bei der Eigenprüfung kann geprüft werden, ob die jeweilige Hochvolt-Komponente 10-28 wie gewünscht funktioniert, also insbesondere keine Funktionsfehler oder -ausfälle vorliegen. Die Selbstdiagnose kann bspw. beim Hochfahren der jeweiligen Hochvolt-Komponente 10-28 und zweckmäßig periodisch während des Betriebs durchgeführt werden. Die Ergebnisse der Selbstdiagnose kann dazu führen, dass bspw. Sicherungen oder Hochvolt-Schütze der jeweilige Hochvolt-Komponente 10-28 öffnen und/oder eine entsprechende Fehlermeldung mittels eines Kommunikations-Busses (z. B. CAN-Bus) an andere Bus-Teilnehmer (Hochvolt-Komponenten) übertragen wird.

Die Selbstdiagnosefunktion kann bspw. auch eine Stromprognose verwendet werden. Aus einer Fahranforderung wird ein Moment angefordert, welches der Inverter 18 stellt. Aus der Traktionsbatterieanordnung 10 wird hierzu eine bestimmte Leistung (Strom/Spannungslage) angefordert (=Stromanforderung). Hierzu gibt es eine Stromprognose in der Traktionsbatterieanordnung 10 (z. B. 1 Sekunde). Falls die Stromprognose nicht mit der Last übereinstimmt, geht die Traktionsbatterieanordnung 10 in einen Fehlerzustand. Der angebotene Strom wird reduziert bzw. gar nicht mehr angeboten. Hier sollten bspw. die jeweiligen Hochvolt-Schütze der Traktionsbatterieanordnung 10 aufgehen, mit oder ohne Lastreduktion. Diese gilt es auch für die Rekuperation zu betrachten. Hier muss die Traktionsbatterieanordnung 10 noch Strom aufnehmen können. Üblicherweise kann der jeweilige Ladezustand der Traktionsbatterien 12, 14, 16 (SoC - state of sharge) als Gradmesser verwendet werden.

Es besteht die Möglichkeit, dass bei der Selbstdiagnose der Traktionsbatterien 12-16 ein Fehlerfall erkannt wird, z. B. weil eine maximale Stromgrenze der jeweiligen Traktionsbatterien 12-16 von bspw. 200 A überschritten wird. Normalerweise würde dies zum Öffnen der jeweiligen Hochvolt-Schütze führen. Allerdings kann bei einem Kurzschlussstrom die betroffene Traktionsbatterie 12-16 bei Verletzung der Stromgrenzen den Strom ggf. nicht mehr sofort reduzieren. Der Strom kann z. B. so hoch sein, dass die Hochvolt -Schütze verschweißen. Es kann zusätzlich in den Traktionsbatterien 12-16 eine Schmelzsicherung (mindestens Minus-Pfad/besser Plus- und Minus-Pfad wegen möglichen Isolationsfehlern) vorhanden sein. Der Übergabebereich zwischen Hochvolt-Schütz und Schmelzsicherung muss definiert sein. Es gibt jedoch (Strom-) Bereiche, in denen es zeitlich dauert, bis die Schmelzsicherung anspricht. Ggf. liegt der Kurzschlussstrom auch in einem (Strom-) Bereich, in dem die Schmelzsicherung nicht sofort anspricht. Das hierin offenbarte Verfahren ermöglicht bspw. in solchen Szenarien, dass steuerungsseitig ein Fehler in der Traktionsbatterieanordnung erkannt werden kann, um (weitere und/oder schnellere) geeignete Gegenmaßnahmen einzuleiten.

In einem Verfahrensschritt S10 wird ein erster elektrischer Summenstrom ∑I_1 (siehe Figur 1) ermittelt, der in Summe der Traktionsbatterieanordnung 10 zugeführt bzw. von dieser angefordert wird und/oder von der Traktionsbatterieanordnung 10 als Stromangebot bereitgestellt wird. Der erste elektrische Summenstrom ∑I_1 ist eine Summe von allen elektrischen Einzelströmen, die zu den Traktionsbatterien 12, 14, 16 zugeführt bzw. diesen angefordert oder von diesen bereitgestellt werden. Typischerweise werden die Traktionsbatterien 12, 14, 16, sofern aktiviert, in einem Normalfahrbetrieb des Kraftfahrzeugs einen entsprechenden elektrischen Einzelstrom als Stromangebot bereitstellen. In einem Rekuperations- oder Traktionsbatterieladebetrieb kann zu zumindest einer der Traktionsbatterien 12, 14, 16 ein elektrischer Einzelstrom zugeführt bzw. von dieser angefordert werden. Insbesondere im Rekuperationsbetrieb kann auch von zumindest einer der Traktionsbatterien 12, 14, 16 ein elektrischer Einzelstrom bereitgestellt werden, zweckmäßig für die elektrischen Nebenverbraucher 24 - 32.

Es ist möglich, dass die elektrischen Einzelströme und/oder der erste elektrische Summenstrom ∑I_1 beispielsweise gemessen, erfasst, angefordert oder berechnet werden. Insbesondere kann der erste elektrische Summenstrom ∑I_1 als Summe von gemessenen, erfassten oder angeforderten elektrischen Einzelströmen berechnet werden.

Beispielsweise können die Traktionsbatterien 12, 14, 16 jeweils eigene Strommesser oder Spannungsmesser (entsprechende Innenwiderstände sind z. B. bekannt und/oder interpolierbar usw.) aufweisen. Die erfassten oder gemessenen elektrischen Einzelströme der Slave-Traktionsbatterien 14 und 16 können als elektrische Signale an eine der Master-Traktionsbatterie 12 zugeordneten Steuerung gesendet werden. Diese Steuerung kann die elektrischen Einzelströme der Traktionsbatterien 12, 14, 16 aufsummieren.

Die elektrischen Einzelströme und Summenströme können derart berücksichtigt werden, dass angeforderte bzw. zugeführte elektrische Ströme ein umgekehrtes Vorzeichen zu bereitgestellten elektrischen Strömen haben.

In einem Verfahrensschritt S12 wird ein zweiter elektrischer Summenstrom ∑I_2 (siehe Figur 1) ermittelt. Der zweite elektrische Summenstrom ∑I_2 wird in Summe von den elektrischen Geräten 18-32 als Stromangebot bereitgestellt und/oder von den elektrischen Geräten 18-32 als Stromanforderung angefordert. Es ist hierbei möglich, dass bspw. der Inverter 18 aufgrund einer Rekuperation der elektrischen Antriebseinheit 20 Strom zuführt, während die übrigen elektrischen Geräte (Nebenverbraucher) 24 - 32 elektrischen Strom zu deren Betrieb anfordern. In Summe kann sich eine Stromanforderung oder ein Stromangebot durch die elektrischen Geräte 18-32 ergeben. Der zweite elektrische Summenstrom ist eine Summe von allen elektrischen Einzelströmen, die zu den elektrischen Geräten 18-32 zugeführt bzw. von diesen angefordert werden. Die elektrischen Einzelströme und/oder der zweite elektrische Summenstrom ∑I_2 können beispielsweise gemessen, erfasst oder berechnet werden. Insbesondere kann der erste elektrische Summenstrom ∑I_2 als Summe von gemessenen oder erfassten elektrischen Einzelströmen der elektrischen Geräte 18-32 berechnet werden. Bspw. kann jedem elektrischen Gerät 18-32 ein entsprechender Strom- oder Spannungsmesser zugeordnet sein. Die Summation der elektrischen Einzelströme kann beispielsweise von einer entsprechenden Steuerung vorgenommen werden.

Der erste elektrische Summenstrom ∑I_1 ist ein elektrischer Strom, der von der Traktionsbatterieanordnung 10 insgesamt aufgenommen oder abgegeben wird. Der zweite elektrische Summenstrom ∑I_2 ist eine elektrischer Strom, der von den elektrischen Geräten 18-32 insgesamt aufgenommen oder abgegeben wird. Die elektrischen Summenströme ∑I_1, ∑I_2 beziehen sich zweckmäßig auf einen gleichen Zeitpunkt, das heißt, beziehen sich auf elektrische Ströme, die gleichzeitig erfasst, angefordert oder gemessen wurden.

Es sollte verstanden werden, das die Ermittlung des ersten elektrischen Summenstroms ∑I_1 und des zweiten elektrischen Summenstroms ∑I_2 als beispielhaft für einen Verfahrensschritt angesehen werden können, bei dem eine Strombilanz aufgestellt wird. Die Strombilanz stellt ein Stromangebot durch die Traktionsbatterieanordnung 10 und die mehreren elektrischen Geräte 18-32 einer Stromanforderung durch die Traktionsbatterieanordnung 10 und die mehreren elektrischen Geräte 18-32 gegenüber. In einem weiteren Verfahrensschritt, wie beispielhaft nachfolgend unter Bezugnahme auf einen Verfahrensschritt S14 beschrieben, kann dann eine Fehlfunktion insbesondere in der Traktionsbatterieanordnung 10 basierend auf einem erkannten Ungleichgewicht in der Strombilanz erkannt werden.

In dem beispielhaften Verfahrensschritt S14 werden der erste elektrische Summenstrom ∑I_1 und der zweite elektrische Summenstrom ∑I_2 miteinander verglichen. Mit anderen Worten gesagt, es wird eine Strombilanz, der alle elektrischen Einzelströme der Traktionsbatterieanordnung 10 und der elektrischen Geräte 18-32 umfasst, aufgestellt. Im Idealfall müssten der erste elektrische Summenstrom ∑I_1 und der zweite elektrische Summenstrom ∑I_2 gleich sein. Beim Vergleich können Toleranzen, zum Beispiel Messtoleranzen und Fertigungstoleranzen berücksichtigt werden. Ergibt der Vergleich unter Berücksichtigung der Toleranzen, dass der erste elektrische Summenstrom ∑I_1 und der zweite elektrische Summenstrom ∑ I_2 eine zu große Abweichung voneinander haben, so wird erkannt, dass eine elektrische Fehlfunktion vorliegt. Wird keine Fehlfunktion erkannt, kann das Verfahren erneut mit dem Schritt S10 fortfahren, um zu einem späteren Zeitpunkt erneut elektrische Summenströme zu ermitteln. Wird eine Fehlfunktion erkannt, so kann das Verfahren mit einem Schritt S16 fortgefahren werden.

Die Erkennung der Fehlfunktion bezüglich der Traktionsbatterieanordnung 10 wird dadurch plausibilisiert, dass durch die beschriebenen Selbstdiagnosen der übrigen HV-Komponenten 18 - 32 andere Fehlerursachen, z. B. in der Last bzw. Stromanforderung, ausgeschlossen werden können bzw. deren Auftrittswahrscheinlichkeit wesentlich reduziert ist.

Beispielsweise kommt es zu einem elektrischen Kurzschluss in der ersten Slave-Traktionsbatterie 14 mit einem Kurzschlussstrom von bspw. 1200 A. Dieser elektrische Einzelstrom der ersten Slave-Traktionsbatterie 14 beeinflusst den ersten elektrischen Summenstrom ∑I_1 dahingehend, dass der erste elektrische Summenstrom ∑I_1, d.h. das Stromangebot, deutlich größer als der zweite elektrische Summenstrom ∑I_2, d.h. die Stromanforderung, ist. Der Unterschied ist dabei so erheblich, dass er nicht mehr durch Messungenauigkeiten erklärbar ist.

In einem weiteren Beispiel sind bspw. sechs parallel verschaltete Traktionsbatterien zugeschaltet. Somit haben alle parallel verschalteten Traktionsbatterien dieselbe Spannungslage. Wegen Alterungserscheinungen können Innenwiderstände und Kapazitäten in gewissen Grenzen variieren. Kommt eine Stromanforderung von dem Inverter 18, dann liefern alle sechs Traktionsbatterien gemäß ihrem Innenwiderstandsverhalten (und auch Ladezustand/ Temperatur) einen Strom an. Jedes System liefert bspw. 200A (ideal angenommen, weil gleiche Produktion mit gleichen Übergangswiderständen/ Zellen, nicht gealtert). Nun tritt ein Kurzschluss in einer der sechs Traktionsbatterien auf. Diese fehlerhafte Traktionsbatterien liefert 1000 A. Alle anderen Traktionsbatterien können aufgrund einer Master-Steuereinheit feststellen, dass Stromangebot (5x200A + 1000A) und Last (1200 A) nicht übereinstimmen. Der Strom in den fünf intakten Traktionsbatterien kann sofort reduziert werden, ggf. werden die Hochvolt-Schütze aufgemacht. Die defekte Traktionsbatterie kann bspw. weiterhin 1000 A liefern, weil die HV-Schütze verschweißt sind und eine entsprechende Schmelzsicherung noch nicht angesprochen ist. Gemäß dem hierin offenbarten Verfahren können weitere Notfallprozeduren eingeleitet werden, um auf die erkannte Abweichung zwischen Stromangebot und Stromnachfrage schnell zu reagieren. Eventuell kommt es auch kurzzeitig zu einem höheren Kurzschlussstrom von bspw. 2400 A. Nun würde am Antrieb das Doppelte vom angeforderten Moment anliegen und es lässt sich so schnell auch nicht durch einen Bremseingriff oder durch Ansprechen der Schmelzsicherung beheben, weil kein definierter Zustand mehr vorliegt. Die Fahrdynamik wäre für den Fahrer nicht mehr kontrollierbar. Durch schnelles Aufrufen von Notfallprozeduren gemäß der vorliegenden Offenbarung kann das Risiko für solche Szenarien wesentlich verringert werden.

Im Schritt S16 können Notfallprozeduren aufgerufen werden, um auf die Fehlfunktion zu reagieren. Insbesondere kann es notwendig sein, unkontrollierte oder unkontrollierbare Fahrzustände des Kraftfahrzeugs schnell zu verhindern. Derartige Fahrzustände können sich beispielsweise ergeben, wenn ein zu großer Strom zu dem Inverter 18 und der elektrischen Antriebseinheit 20 zugeführt werden. Ein ungewünschter und nicht vorhersehbarer Drehmomentschub kann beispielsweise zum Ausbrechen des Fahrzeugs führen. Um derartige unkontrollierbare Fahrzustände zu verhindern, kann beispielsweise der Inverter 18 im Schritt S16 in einen aktiven Kurzschluss geschaltet werden. Zusätzlich kann die Traktionsbatterieanordnung 10 oder einzelne Traktionsbatterien der Traktionsbatterieanordnung 10 beispielsweise ausgeschaltet oder in einen Notfallmodus geschaltet werden. Beispielsweise trägt, nachdem ein Kurzschlussstrom erkannt wurde, ein Potenzialausgleich so lange den Strom, bis es zu einem sicheren Abschalten des elektrischen Stroms kommt. Der elektrische Strom von der Traktionsbatterieanordnung 10 bzw. den Traktionsbatterien 12, 14 und 16 wird über eine oder mehrere entsprechende Sicherungen oder Hochvolt-Schütze, falls noch möglich, abgeschaltet.

In der beispielhaft offenbarten Master-Slave-Traktionsbatterieanordnung 10 können die Slave-Traktionsbatterien 14 und 16 so konfiguriert sein, dass sie der Steuerung, die der Master-Traktionsbatterie 12 zugeordnet ist, Informationen bzw. elektrische Signale zusenden, die eine Kennung bzw. ID der jeweiligen Slave-Traktionsbatterie 14, 16, einen Betriebszustand der jeweiligen Slave-Traktionsbatterie 14, 16 und einen elektrischen Einzelstromwert der jeweiligen Slave-Traktionsbatterie 14, 16 angeben. Mittels der Kennung kann von der Steuerung, die der Master-Traktionsbatterie 12 zugeordnet ist, eine eindeutige Zuordnung hinsichtlich des Betriebszustands und des elektrischen Einzelstroms vorgenommen werden. Der Steuerung ist damit bekannt, wie viele Slave-Traktionsbatterien vorhanden sind (zum Beispiel zwei Traktionsbatterien im gezeigten Ausführungsbeispiel). Der Steuerung ist ferner bekannt, welchen Betriebszustand die Traktionsbatterien 12, 14 aufweisen. Beispielhafte Betriebszustände können sein Aus, Ein, Antriebsmodus, Lademodus, Drive-Modus, Balancing-Modus usw. Die Kennung ermöglicht beispielsweise eine Identifikation derjenigen Slave-Traktionsbatterie, die die Fehlfunktion verursacht hat. Diejenige Slave-Traktionsbatterie, die die Fehlfunktion hat, kann jetzt sicher abgeschaltet werden, wobei der Potenzialausgleich den Strom bis zum sicheren Abschalten trägt. Die Abschaltung erfolgt über eine entsprechende Sicherung oder entsprechende Hochvolt-Schütze, falls die Hochvolt-Schütze noch geöffnet werden können. Alle anderen Traktionsbatterien werden so gesteuert, dass deren Hochvolt-Schütze geöffnet werden. Dies dient dem Eigenschutz der anderen Traktionsbatterien und der Trennung der Traktionsbatterieanordnung 10 vom Hochvolt-Bordnetz 34. Die Kenntnis zum Betriebszustand kann bspw. zur Plausibilisierung des jeweils gemessenen elektrischen Einzelstromes verwendet werden.

Es ist möglich, dass im Schritt S14 nicht nur ein erster elektrischer Summenstrom I_1 und ein zweiter elektrischer Summenstrom I_2 miteinander verglichen werden. Stattdessen können beispielsweise mehrere erste elektrische Summenströme ∑I_1 und mehrere zweite elektrische Summenströme ∑I_2, die sich jeweils auf verschiedene Zeitpunkte beziehen, miteinander verglichen werden. Insbesondere können somit zeitliche Veränderungen oder Gradienten der elektrischen Summenströme ∑I_1, I_2 (bzw. des Stromangebots und der Stromanforderung) miteinander verglichen werden und insbesondere plötzliche Veränderungen identifiziert werden. Weichen die Stromgradienten beispielsweise zu sehr voneinander ab, kann eine Fehlfunktion erkannt werden. Die Einbeziehung von Stromgradienten bei der Erkennung von Fehlfunktionen ermöglicht, sehr schnell auf sich noch ausbildende oder sich gerade ausgebildete Fehlfunktionen zu reagieren. Während der Vergleich von einzelnen Werten für die elektrischen Summenströme ∑I_1 und ∑I_2 noch ein unauffälliges Ergebnis innerhalb eines Toleranzbereichs ergeben kann, so kann ein entsprechender Vergleich der Stromgradienten bereits auf eine Fehlfunktion hinweisen.

Insbesondere kann beim Gradientenvergleich ein Stromgradient am Inverter 18 verglichen werden mit einem Stromgradient an der Traktionsbatterieanordnung 10 und/oder mit einzelnen Stromgradienten an den Traktionsbatterien 12, 14 und/oder 16.

Auch wenn das hierin offenbarte Verfahren unter Bezugnahme auf eine Master-Slave-Traktionsbatterieanordnung beschrieben wurde, ist eine Anwendung in anderen Systemen, zum Beispiel verteilten Traktionsbatterieanordnungen, möglich.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen. Insbesondere beansprucht die Erfindung auch Schutz für den Gegenstand und die Merkmale der Unteransprüche unabhängig von den in Bezug genommenen Ansprüchen. Insbesondere sind die Merkmale des unabhängigen Anspruchs 1 unabhängig voneinander offenbart.

### Bezugszeichenliste

- 10: Traktionsbatterieanordnung
- 12: Master-Traktionsbatterie
- 14: Erste Slave-Traktionsbatterie
- 16: Zweite Slave-Traktionsbatterie
- 18: Inverter
- 20: Elektrische Antriebseinheit
- 22: Bordladegerät
- 24: Heizer
- 26: Luftkompressor
- 28: Bordnetzladewandler
- 30: Niedrigvolt-Bordnetz
- 32: Niedrigvolt-Geräte
- 34: Hochvolt-Bordnetz

## Patentansprüche

1. Verfahren zur Erkennung einer Fehlfunktion, insbesondere eines Kurzschlussstroms, in einer Traktionsbatterieanordnung (10) mit mehreren miteinander verbundenen, insbesondere parallel geschalteten, Traktionsbatterien (12, 14, 16) in einem Kraftfahrzeug mit mehreren elektrischen Geräten (18 - 32), aufweisend:
Aufstellen einer Strombilanz, die ein Stromangebot durch die Traktionsbatterieanordnung (10) und die mehreren elektrischen Geräte (18 - 32) einer Stromanforderung durch die Traktionsbatterieanordnung (10) und die mehreren elektrischen Geräte (18 - 32) gegenüberstellt; und
Erkennen einer Fehlfunktion basierend auf einem Ungleichgewicht in der Strombilanz.

2. Verfahren nach Anspruch 1, wobei der Schritt des Aufstellens der Strombilanz aufweist:
Ermitteln eines ersten elektrischen Summenstroms, der in Summe von der Traktionsbatterieanordnung (10) angefordert oder bereitgestellt wird; und
Ermitteln eines zweiten elektrischen Summenstroms, der in Summe von den mehreren elektrischen Geräten (18 - 32) angefordert oder von den mehreren elektrischen Geräten (18 - 32) bereitgestellt wird.

3. Verfahren nach Anspruch 2, wobei:
der Schritt des Erkennens einer Fehlfunktion auf einem Unterschied zwischen dem ersten elektrischen Summenstrom und dem zweiten elektrischen Summenstrom basiert.

4. Verfahren nach Anspruch 2 oder Anspruch 3, wobei:
der erste elektrische Summenstrom als eine Summe von allen elektrischen Einzelströmen, die von den mehreren Traktionsbatterien (12, 14, 16) angefordert und von den mehreren Traktionsbatterien (12, 14, 16) bereitgestellt werden, ermittelt wird.

5. Verfahren nach einem der Ansprüche 2 bis 4, wobei:
die mehreren elektrischen Geräte (18 - 32) einen Inverter (18), der einer elektrischen Antriebseinheit (20) zugeordnet ist, mindestens einen elektrischen Nebenverbraucher (24 - 32) und/oder ein Bordladegerät (22) aufweisen; und
der zweite elektrische Summenstrom als eine Summe von allen elektrischen Einzelströmen, die von dem Inverter (18) und dem Bordladegerät (22) bereitgestellt und von den elektrischen Nebenverbrauchern (24 - 32) und dem Inverter (18) oder der Antriebseinheit (20) angefordert werden, ermittelt wird.

6. Verfahren nach einem der vorherigen Ansprüche, wobei:
eine Fehlfunktion erkannt wird, wenn das Ungleichgewicht außerhalb eines vorbestimmten Toleranzbereichs liegt.

7. Verfahren nach einem der Ansprüche 2 bis 6, wobei:
ein elektrischer Kurzschluss in der Traktionsbatterieanordnung (10) erkannt wird, wenn unter Berücksichtigung eines vorbestimmen Toleranzbereichs der erste elektrische Summenstrom größer als der zweite elektrische Summenstrom ist.

8. Verfahren nach einem der Ansprüche 2 bis 7, wobei:
der erste elektrische Summenstrom und der zweite elektrische Summenstrom sich auf einen gleichen Zeitpunkt beziehen; und/oder
die elektrischen Einzelströme zu einem gleichen Zeitpunkt erfasst, insbesondere gemessen, werden.

9. Verfahren nach einem der vorherigen Ansprüche, wobei:
die Traktionsbatterieanordnung (10) eine Master-Slave-Anordnung ist, mit einer Master-Traktionsbatterie (12) und mehreren, insbesondere parallel geschalteten, Slave-Traktionsbatterien (14, 16).

10. Verfahren nach Anspruch 9, wobei:
die mehreren Slave-Traktionsbatterien (14, 16) jeweils ein Signal, das einen Betriebszustand der jeweiligen Slave-Traktionsbatterie (14, 16) angibt, an eine der Master-Traktionsbatterie (12) zugeordnete Steuerung übertragen; und/oder
die mehreren Slave-Traktionsbatterien (14, 16) jeweils ein Signal, das den jeweils angeforderten oder bereitgestellten elektrischen Einzelstrom angibt, an eine der Master-Traktionsbatterie (12) zugeordnete Steuerung übertragen; und/oder
Signale der Slave-Traktionsbatterien (14, 16) mit einer eindeutigen Kennung zur Identifikation der jeweiligen Slave-Traktionsbatterie (14, 16) übertragen werden.

11. Verfahren nach Anspruch 10, wobei:
die Steuerung, die der Master-Traktionsbatterie (12) zugeordnet ist, den ersten elektrischen Summenstrom basierend auf einem Signal, das dessen angeforderten oder bereitgestellten elektrischen Einzelstrom angibt, und den von den Slave-Traktionsbatterien (14, 16) empfangenen Signalen ermittelt.

12. Verfahren nach Anspruch 11, ferner aufweisend:
Identifizieren, und insbesondere Abschalten, einer Slave-Traktionsbatterie (14, 16) mit der Fehlfunktion, insbesondere einem elektrischen Kurzschluss, basierend auf den Kennungen und den Signalen von den Slave-Traktionsbatterien (14, 16).

13. Verfahren nach einem der vorherigen Ansprüche, ferner aufweisend:
Erkennen einer Fehlfunktion basierend auf einer zeitlichen Veränderung und/oder eines Gradienten des Stromangebots, der Stromanforderung, des Ungleichgewichts, des ersten elektrischen Summenstroms, des zweiten elektrischen Summenstrom, der elektrischen Einzelströme und/oder des Unterschieds; und/oder
Erkennen einer Fehlfunktion basierend auf einem Vergleich zwischen einer zeitlichen Veränderung und/oder eines Gradienten eines elektrischen Einzelstroms an einem Inverter (18), der einer elektrischen Antriebseinheit (20) des Kraftfahrzeugs zugeordnet ist, und einer zeitlichen Veränderung und/oder eines Gradienten des ersten elektrischen Summenstroms und/oder von elektrischen Einzelströmen der mehreren Traktionsbatterien (12, 14, 16) der Traktionsbatterieanordnung (10).

14. Verfahren nach einem der vorherigen Ansprüche, ferner aufweisend:
Schalten eines Inverters (18), der einer elektrischen Antriebseinheit (20) des Kraftfahrzeugs zugeordnet ist, in einen aktiven Kurzschluss, wenn eine Fehlfunktion erkannt wird.

15. Kraftfahrzeug, insbesondere Nutzfahrzeug, mit:
einer Traktionsbatterieanordnung (10), die mehrere miteinander verbundene, insbesondere parallel geschaltete, Traktionsbatterien (12, 14, 16) aufweist; und
einer Steuerung, die zum Ausführen eines Verfahrens nach einem der vorherigen Ansprüche eingerichtet ist.
